# EUROPÄISCHE PATENTANMELDUNG

(11) **EP 0 875 991 A1**
(43) Veröffentlichungstag der Anmeldung: **04.11.1998**
(21) Anmeldenummer: 98201203.1
(22) Anmeldetag: 15.04.1998
(51) Int. Cl.: H03H 11/46, H01L 27/02

(54) **Schaltungsanordnung zur Generierung eines elektronisch gesteuerten Widerstandes**

(30) Priorität: 25.04.1997 DE 19717551; 24.09.1997 DE 19742009
(71) Anmelder: Philips Patentverwaltung GmbH, 22335 Hamburg (DE); Koninklijke Philips Electronics N.V., 5621 BA Eindhoven (NL)
(72) Erfinder: Berg, Michael, Röntgenstrasse 24, 22335 Hamburg (DE); Gehrt, Holger, Röntgenstrasse 24, 22335 Hamburg (DE)
(74) Vertreter: von Laue, Hanns-Ulrich, Dipl.-Ing.

(57) **Zusammenfassung**

Bei einer Schaltungsanordnung zur Generierung eines elektronisch gesteuerten elektrischen Widerstandes mittels wenigstens eines MOS-Transistors, dessen Source-Drain-Strecke zur Generierung des elektrischen Widerstandes eingesetzt wird, der zwischen einem ersten und einem zweiten Anschluß generiert wird, sind zur Erzielung einer möglichst guten Linearität des elektrischen Widerstandes Mittel zur Generierung eines Bulk-Signals vorgesehen, welche aus der Spannung an dem mit dem Source-Anschluß eines zugeordneten MOS-Transistor gekoppelten Anschluß der Schaltungsanordnung ein Signal zur Ansteuerung eines Bulk-Anschlusses des zugeordneten MOS-Transistors generieren, welches aus der Spannung an dem Anschluß und einer zusätzlich überlagerten Gleichspannung eines solchen Vorzeichens generiert wird, daß abhängig von der Dotierungsart des MOS-Transistors eine Bildung einer Diode zwischen dessen Source- und Bulk-Gebieten vermieden wird.

## Beschreibung

Die Erfindung betrifft eine Schaltungsanordnung zur Generierung eines elektronisch gesteuerten elektrischen Widerstandes mittels wenigstens eines MOS-Transistors, dessen Source-Drain-Strecke zur Generierung des elektrischen Widerstandes eingesetzt wird, der zwischen einem ersten und einem zweiten Anschluß generiert wird.

Bei der Herstellung von Signalverabeitungsschaltungen in einem BIMOS oder CMOS IC besteht das Problem, Widerstände mit genügender Genauigkeit herzustellen. Ferner sind hochohmige Widerstände kostengünstig auf einem derarigen IC nicht zu realisieren. Hierzu sind nach dem Stande der Technik Schaltungen bekannt, welche auf elektronische Weise einen Widerstand erzeugen. Hierzu wird beispielsweise die Source-Drain-Strecke eines MOS-Transistors eingesetzt. Diese Strecke bildet zwischen zwei Anschlüssen der Schaltungsanordnung einen elektronisch erzeugten und elektronisch steuerbaren Widerstand. Hierbei besteht bei den bekannten Schaltungsanordnungen das Problem, daß der Widerstand, den der MOS-Transistor erzeugt, nichtlinear ist, d.h. daß der Widerstandswert abhängig von der an die Anschlüsse angelegten Spannung ist. Dies ist eine Folge der nichtlinearen Drain-Source-Kennlinie eines MOS-Transistors. Ferner besteht bei derartigen Schaltungsanordnungen das Problem, daß je nach Aussteuerung des Source-Anschlusses des MOS-Transistors dessen Potential in die Größenordnung der Bulk-Spannung des MOS-Transistors kommen kann. Es bildet sich dann zwischen dem Bulk-Gebiet des Transistors und dem Source-Anschluß oder Drain-Anschluß eine Diode, die zu Begrenzungseffekten führt und damit das den Transistor passierende Signal verzerrt. Bevor diese Effekte wirksam werden, bewirkt die Bulk-Source/Bulk-Drain-Diode eine mit der Spannung am gesteuerten Widerstand zunehmende Nichtlinearität. Dieser Effekt ist als "back gate effect" bekannt.

Es ist Aufgabe der Erfindung, eine Schaltungsanordnung der eingangs genannten Art anzugeben, welche möglichst linear arbeitet und bei welcher die Bildung von kapazitiv wirkenden Dioden innerhalb des Bulk-Gebietes vermieden wird.

Diese Aufgabe ist erfindungsgemäß dadurch gelöst, daß Mittel zur Generierung eines Bulk-Signals vorgesehen sind, welche aus der Spannung an dem mit dem Source-Anschluß eines zugeordneten MOS-Transistor gekoppelten Anschluß der Schaltungsanordnung ein Signal zur Ansteuerung eines Bulk-Anschlusses des zugeordneten MOS-Transistors generieren, welches aus der Spannung an dem Anschluß und einer zusätzlich überlagerten Gleichspannung eines solchen Vorzeichens generiert wird, daß abhängig von der Dotierungsart des MOS-Transistors eine Bildung einer leitenden Diode zwischen dessen Source- und Bulk-Gebieten über einen weiten Spannungsbereich vermieden wird.

Ein MOS-Transistor, wie er hier zur Erzeugung eines elektronisch gesteuerten Widerstandes eingesetzt wird, weist Source- und Drain-Anschlüsse einer ersten Dotierungsart auf. Zwischen den Source- und Drain-Anschlüssen erstreckt sich der Gate-Anschluß, mittels dessen der Transistor steuerbar ist. Der Transistor ist insgesamt in einem sogenannten Bulk-Gebiet aufgebaut, das eine zweite Dotierungsart aufweist. Bei der Arbeitsweise derartiger Transistoren besteht das Problem, daß das Source-Potential immer kleiner sein soll, als das Potential des Bulk-Gebietes. Erreichen hingegen beide Gebiete ein ähnliches Potential, so bildet sich zwischen dem Source-Anschluß und dem Bulk-Gebiet eine Diode, die das dem Source-Anschluß des Transistors zugeführte Signal kapazitiv und gleichstrommäßig belastet, so daß eine Verfälschung bzw. Veränderung des Signals eintritt.

Einerseits um diesen Störeffekt zu vermeiden und andererseits um jederzeit in einem möglichst linearen Bereich der Drain-Source-Kennlinie des Transistors zu arbeiten, sind erfindungsgemäß Mittel zur Generierung eines Bulk-Signals vorgesehen, welches sicherstellt, daß die Bildung der oben beschriebenen leitenden Diode vermieden wird und daß der Transistor jeweils in einem solchen Bereich betrieben wird, in dem er möglichst linear arbeitet. Dies wird dadurch erreicht, daß die Mittel zur Generierung eines Bulk-Signals dieses in der Weise generieren, daß sich das Bulk-Signal aus der Überlagerung der Spannung an denjenigen Anschluß der Schaltungsanordnung, der mit dem Source-Anschluß des MOS-Transistors gekoppelt ist, und einer zusätzlichen Gleichspannung zusammensetzt. Es wird also der von außen dem Source-Anschluß des Transistors zugeführten Signalspannung zusätzlich eine Gleichspannung überlagert. Dieses überlagerte Signal wird als Bulk-Signal dem Bulk-Anschluß des MOS-Transistors zugeführt. Damit wird erreicht, daß das Potential des Bulk-Anschlusses und damit des Bulk-Gebietes des Transistors jederzeit höher ist als das Potential des Source-Gebietes des Transistors. Damit wird auch die Wirkung des kapazitiven Belags der Diode zum Bulk vermieden.

Im Ergebnis erzeugt die Schaltungsanordnung somit einen elektronisch generierten Widerstand, dessen Wert durch die Wahl der Gate-Spannung des Transistors einstellbar ist, und dessen Wert weitgehend linear und frei von störenden kapazitiven Effekten ist.

Gemäß der nach Anspruch 2 vorgesehenen Ausgestaltung der Erfindung wird erreicht, daß die Schaltungsanordnung auch bei unsymmetrischer Aussteuerung der beiden Anschlüsse die oben genannten Vorteile uneingeschränkt aufweist.

Die Mittel zur Generierung des oder der Bulk-Signale können vorteilhaft, wie gemäß Anspruch 3 vorgesehen ist, Transistoren aufweisen, welche sich in einfacher Weise dazu eignen, dem Bulk-Signal des MOS-Transistors im Vergleich zu dem Source-Signal eine zusätzliche Gleichspannung zu überlagern, welche durch eine Diodenstrecke des Transistors auf relativ einfache Weise erzeugt werden kann.

Beispielsweise wird bei der Ausgestaltung nach Anspruch 4 die Basis-Emitter-Potentialdifferenz eines PNP-Bipolar-Transistors dazu eingesetzt, dem mit dem Source-Gebiet des MOS-Transistors gekoppelten Potential zur Erzeugung des Bulk-Signals zusätzlich ein Gleichspannungspotential zu überlagern.

Gemäß der Ausgestaltung nach Anspruch 5 wird dieses in entsprechender Weise bei einem NPN-Bipolar-Transistor vorgenommen.

Bei den Ausgestaltungen der Erfindung gemäß den Ansprüchen 6 und 7 werden PMOS- bzw. NMOS-Transistoren in den Mitteln zur Generierung des Bulk-Signals eingesetzt. Bei diesen Transistoren wird die Gate-Source-Strecke zur Erzeugung der Potentialdifferenz genutzt. Voraussetzung für den Einsatz von MOS-Transistoren ist hierbei, daß die Bulk-Anschlüsse frei verfügbar sind.

Mittels der Ausgestaltung der Erfindung nach Anspruch 8 wird der Vorteil einer weiterverbesserten Linearität erreicht. Die vorgesehenen ohmschen Widerstände weisen dabei relativ kleine Werte auf. Sie bewirken jedoch, daß die mittels der Transistoren zu erzeugenden Widerstandswerte größer sein können. Die relativ kleinen ohmschen Widerstände können auf integrierten Schaltkreisen noch relativ einfach erzeugt werden.

Nachfolgend werden drei Ausführungsbeispiele der Erfindung anhand der Zeichnung näher erläutert. Es zeigen:
Fig. 1 ein Schaltbild einer ersten Ausführungsform der Erfindung, bei welcher PNP-Bipolar-Transistoren zur Erzeugung der Bulk-Spannung eingesetzt werden und bei der PMOS-Transistoren zur Erzeugung der elektrisch generierten Widerstände eingesetzt werden,
Fig. 2 eine zweite Ausführungsform einer Schaltungsanordnung, bei der den Source-Drain-Strecken der PMOS-Transistoren Widerstände in Reihe geschaltet sind und
Fig. 3 eine dritte Ausführungsform, bei der ausschließlich MOS-Transistoren eingesetzt werden.

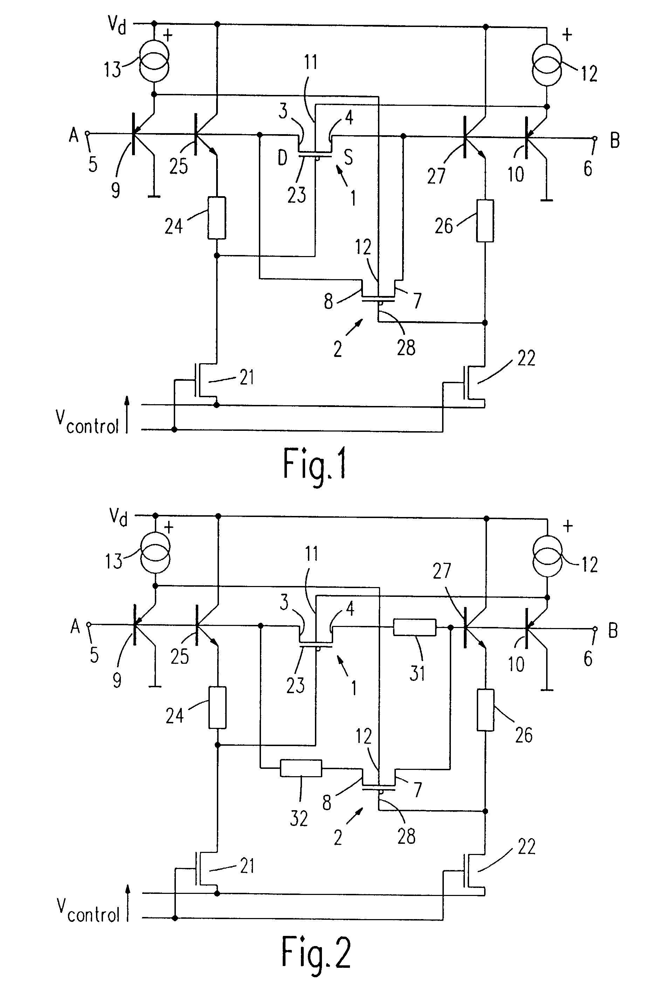

In der Schaltungsanordnung der ersten Ausführungsform, die in Fig. 1 dargestellt ist, werden ein erster PMOS-Transistor 1 und ein zweiter PMOS-Transistor 2 zur Erzeugung des Widerstandes eingesetzt. Die Source-Drain-Stecken der beiden PMOS Transistoren 1 und 2 sind dabei parallelgeschaltet.

Der erste PMOS-Transistor 1 weist einen Source-Anschluß 4 auf, der mit einem zweiten Anschluß 6 der Schaltungsanordnung gekoppelt ist. Er weist ferner einen Drain-Anschluß 3 auf, der mit einem ersten Anschluß 5 der Schaltungsanordnung gekoppelt ist.

Der zweite PMOS-Transistor 2 weist einen Source-Anschluß 8 auf, der mit dem ersten Eingang 5 gekoppelt ist, sowie einen Drain-Anschluß 7, der mit dem zweiten Anschluß 6 der Schaltungsanordnung gekoppelt ist.

Die Schaltungsanordnung gemäß Fig. 1 weist ferner erste Mittel 10 zur Generierung eines Bulk-Signals für den ersten PMOS-Transistor 1 sowie zweite Mittel 9 zur Generierung eines Bulk-Signals für den zweiten PMOS-Transistor 2 auf. Bei den Mitteln 9 bzw. 10 handelt es sich bei diesem Ausführungsbeispiel um PNP-Bipolar-Transistoren.

In den ersten Mitteln 10 zur Generierung des Bulk-Signals für den ersten PMOS-Transistor 1 ist ein PNP-Transistor vorgesehen, dessen Kollektor mit einem Bezugspotential, dessen Basis-Anschluß mit dem zweiten Anschluß 6 der Schaltungsanordnung und dem Source-Anschluß 4 des ersten PMOS-Transistors gekoppelt ist. Der Emitter des in den Mitteln 10 vorgesehenen PNP-Transistors ist mit einem Bulk-Anschluß 11 des ersten PMOS-Transistors gekoppelt. Er ist ferner über eine Stromquelle 13 mit einem Versorgungspotential VD gekoppelt.

In den zweiten Mitteln 9 zur Generierung eines Bulk-Signals ist ebenfalls ein PNP-Transistor vorgesehen, der in entsprechender Weise mit dem Bezugspotential, dem ersten Eingang 5, einem Bulk-Anschluß 12 des zweiten PMOS-Transistors 2 sowie über eine Stromquelle 14 mit dem Versorgungspotential gekoppelt ist.

Die in den Mittel 9 bzw. 10 vorgesehenen PNP-Transistoren sind dabei so verschaltet, daß die über der Basis-Emitter-Strecke abfallende Spannung dazu eingesetzt wird, daß die den Bulk-Anschlüssen 11 bzw. 12 der Transistoren 1 bzw. 2 zugeführten Bulk-Spannungen jeweils um diese Potentialdifferenz höher sind als die ihren Source-Anschlüssen zugeführten Spannungen. So wird beispielsweise die an dem zweiten Anschluß der Schaltungsanordnung anliegende Spannung einerseits dem Source-Anschluß 4 des ersten PMOS-Transistors 1 zugeführt. Ferner wird diese Spannung mittels des in den ersten Mitteln vorgesehenen PNP-Transistors zusätzlich um die Potentialdifferenz der Basis-Emitter-Strecke des PNP-Transistors erhöht dem Bulk-Anschluß 11 des gleichen PMOS-Transistors 1 zugeführt. Damit gelangt an den Bulk-Anschluß 11 des ersten Transistors 1 das gleiche Signal wie an dessen Source-Anschluß, jedoch erhöht um die Dioden-Strecke der Basis-Emitter-Strecke des in den Mitteln 10 vorgesehenen PNP-Transistors, deren Potentialdifferenz etwa 0,7 Volt beträgt. Damit wird erreicht, daß bei jedweder Änderung des an dem Anschluß 6 vorhandenen Signals, jeweils eine solche Potentialdifferenz zwischen dem Source- und dem Bulk-Anschluß des Transistors 1 erzielt wird, daß die Bildung einer Kapazitätsdiode zwischen dem Source-Anschluß und dem Bulk-Gebiet vermieden wird.

In entsprechender Weise gilt dies für den zweiten PMOS-Transistor 2 und des mittels der zweiten Mittel 9 erzeugten Bulk-Signals.

In der Schaltungsanordnung gemäß Fig. 1 sind ferner zwei NMOS-Transistoren 21 und 22 vorgesehen, deren Source-Anschlüsse mit einem Bezugspotential und deren Gate-Anschlüsse mit einem Steuerpotential Vcontrol gekoppelt sind. Der Drain-Anschluß des ersten Transistors 21 ist mit einem Gate-Anschluß 23 des ersten PMOS-Transistors 1 sowie über einen Widerstand 24 mit dem Emitter eines dritten PNP-Transistors 25 gekoppelt. Der Basisanschluß des dritten PNP-Transistors 25 ist mit dem ersten Eingang 5 der Schaltungsanordnung und dessen Kollektor mit dem Versorgungspotential V_{d} gekoppelt. In entsprechender Weise ist der Drain-Anschluß des zweiten NMOS-Transistors 22 mit dem Gate-Anschluß des zweiten PMOS-Transistors 2 sowie über einen Widerstand 26 mit einem vierten PNP-Bipolar-Transistor 27 gekoppelt, welcher in entsprechender Weise wie der dritte PNP-Bipolar-Transistor 25 verschaltet ist, wobei der Transistor 27 mit dem Source-Anschluß 4 des ersten PMOS-Transistors 1 gekoppelt ist. Der Drain-Anschluß des zweiten NMOS-Transistors 22 ist mit einem Gate-Anschluß 28 des zweiten PMOS-Transistors 2 gekoppelt.

Mittels des Steuerpotentials Vcontrol kann das Potential an den Gate-Anschlüsse 23 bzw. 28 der PMOS-Transistoren 1 bzw. 2 gesteuert werden, wodurch die Widerstände der Source-Drain-Strecken der beiden Transistoren 1 und 2 steuerbar sind. Damit kann mittels des Steuerpotentials Vcontrol der elektrisch steuerbare Widerstand der Schaltungsanordnung zwischen deren Anschlüssen 5 und 6 eingestellt werden.

Anstelle der PMOS-Transistoren 1 und 2 können auch NMOS-Transistoren eingesetzt werden. In entsprechender Weise können statt der in den Mitteln 9 und 10 vorgesehenen PNP-Transistoren auch NPN-Transistoren vorgesehen sein.

In Fig. 2 ist eine zweite Ausführungsform der Erfindung dargestellt. Die Schaltungsanordnung gemäß Fig. 2 entspricht derjenigen gemäß Fig. 1 mit der Ausnahme, daß zwischen den Source-Anschluß 4 des ersten Transistors 1 und den ersten Anschluß 6 der Schaltungsanordnung ein ohmscher Widerstand 31 und zwischen den Source-Anschluß 8 des zweiten PMOS-Transistors 2 und den ersten Anschluß 5 der Schaltungsanordnung ein zweiter ohmscher Widerstand 32 geschaltet sind.

In dieser Ausführungsform ist also den Source-Drain-Strecken der beiden PMOS-Transistoren 1 und 2 jeweils ein ohmscher Widerstand 31 bzw. 32 in Reihe geschaltet.

Dabei sind die Widerstandswerte der ohmschen Widerstände 31, 32 im Verhältnis zu demjenigen Widerstand, der zwischen den Anschlüssen 5 und 6 eingestellt werden soll, relativ klein gewählt. Damit wird einerseits erreicht, daß die Widerstände 31 und 32 auf dem Substrat eines integrierten Schaltkreises noch relativ leicht herstellbar sind. Andererseits müssen die Widerstandswerte, die mittels der Source-Drain-Strecken der beiden PMOS-Transistoren 1 und 2 erzeugt werden, kleiner sein. Damit wird eine weiter verbesserte Linearität der Schaltung erreicht.

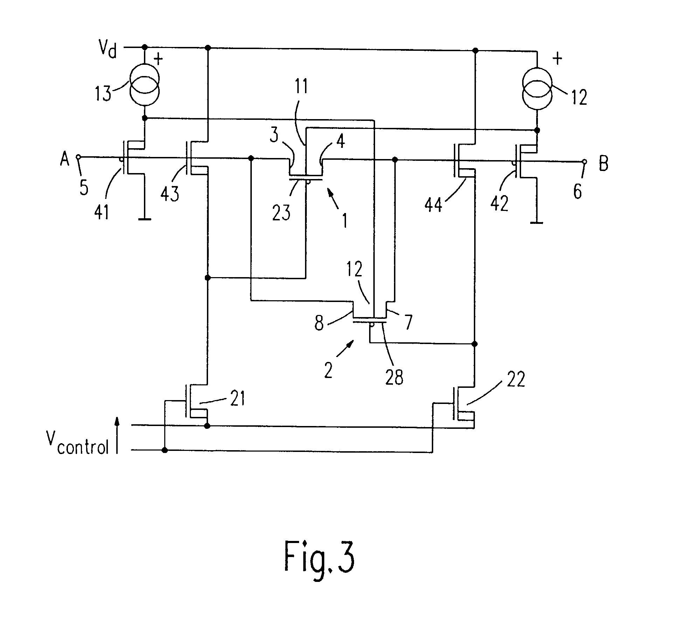

Bei einer in Fig. 3 dargestellten dritten Ausführungsform der Erfindung sind erste Mittel 42 zur Generierung des Bulk-Signals sowie zweite Mittel 41 vorgesehen, in welchen anstelle der PNP-Bipolar-Transistoren der Ausführungsformen gemäß Fig. 1 und 2 PMOS-Transistoren eingesetzt werden. Ferner sind die dritten und vierten PNP-Bipolar-Transistoren 25 und 27 der beiden Ausführungsform gemäß Fig. 1 und 2 durch NMOS-Transistoren 43 und 44 ersetzt worden. Damit kann die Schaltungsanordnung gemäß Fig. 3 ausschließlich in einem MOS-Prozeß gefertigt werden, wobei jedoch Voraussetzung ist, daß die Bulk-Anschlüsse der Transistoren 41 bis 44 extern zugänglich sind.

Der in den ersten Mitteln 42 vorgesehene PMOS-Transistor ist mit seinem Drain-Anschluß mit Bezugspotential und mit seinem Gate-Anschluß mit dem zweiten Eingang 6 der Schaltungsanordnung sowie mit dem Source-Anschluß 4 des ersten PMOS-Transistors gekoppelt. Die Source- und Drain-Anschlüsse des in den Mitteln 42 vorgesehenen PMOS-Transistors sind einerseits mit dem Bulk-Anschluß 11 des ersten PMOS-Transistors 1 sowie andererseits über eine Stromquelle 13 mit dem Versorgungspotential V_{d} gekoppelt. Damit wird erreicht, daß das Bulk-Signal jeweils um die Potentialdifferenz der Gate-Source-Strecke des PMOS-Transistors höher ist als das an dem zweiten Eingang 6 der Schaltungsanordnung zugeführte Eingangssignal. Damit werden die gleichen Vorteile erzielt, wie in der Schaltungsanordnung gemäß Fig. 1.

In entsprechender Weise ist der in den zweiten Mitteln 41 vorgesehene PMOS-Transistor mit Bezugspotential, mit dem ersten Anschluß 5 der Schaltungsanordnung, dem Source-Anschluß 8 des zweiten PMOS-Transistors 2, mit dem Bulk-Anschluß 12 des zweiten PMOS-Transistors 2 sowie mit Versorgungspotential gekoppelt.

Um in der Schaltungsanordnung gemäß Fig. 3 gänzlich auf Bipolar-Transistoren verzichten zu können, sind gegenüber den Schaltungsanordnungen gemäß Fig. 1 und 2 die Transistoren 25 und 27 ebenfalls durch MOS-Transistoren ersetzt worden, nämlich durch MOS-Transistoren 43 und 44.

Dabei sind die Bulk- und Source-Anschlüsse der NMOS-Transistoren 43 und 44 jeweils mit den Drain-Anschlüssen der Transistoren 21 und 22 und die Drain-Anschlüsse der Transistoren 43 und 44 jeweils mit dem Versorgungspotential gekoppelt. Der Gate-Anschluß des Transistors 43 ist mit dem ersten Eingang 5 der Schaltungsanordnung und der Gate-Anschluß des Transistors 44 mit dem zweiten Gate-Anschluß 6 der Schaltungsanordnung gekoppelt. Auch in dieser Ausführungsform dienen die Transistoren 43 und 44 gemeinsam mit den Transistoren 21 und 22 zur Einstellung der Gate-Potentiale der PMOS-Transistoren 1 und 2 und damit zur Einstellung des elektrischen Widerstandes der Schaltungsanordnung zwischen deren Anschlüssen 5 und 6.

## Patentansprüche

1. Schaltungsanordnung zur Generierung eines elektronisch gesteuerten elektrischen Widerstandes mittels wenigstens eines MOS-Transistors, dessen Source-Drain-Strecke zur Generierung des elektrischen Widerstandes eingesetzt wird, der zwischen einem ersten und einem zweiten Anschluß generiert wird, dadurch gekennzeichnet,
daß Mittel zur Generierung eines Bulk-Signals vorgesehen sind, welche aus der Spannung an dem mit dem Source-Anschluß eines zugeordneten MOS-Transistor gekoppelten Anschluß der Schaltungsanordnung ein Signal zur Ansteuerung eines Bulk-Anschlusses des zugeordneten MOS-Transistors generieren, welches aus der Spannung an dem Anschluß und einer zusätzlich überlagerten Gleichspannung eines solchen Vorzeichens generiert wird, daß abhängig von der Dotierungsart des MOS-Transistors eine Bildung einer Diode zwischen dessen Source- und Bulk-Gebieten vermieden wird.

2. Schaltungsanordnung nach Anspruch 1, dadurch gekennzeichnet,
daß zwei MOS-Transistoren vorgesehen sind, deren Source-Drain-Strecken in Parallelschaltung den elektrisch steuerbaren Widerstand bilden und denen jeweils Mittel zur Generierung eines Bulk-Signals zugeordnet sind, von denen erste Mittel ein Bulk-Signal aus der Spannung an einem ersten Anschluß des gesteuerten Widerstandes für den den ersten Mitteln zugeordneten MOS-Transistor generieren und von denen zweite Mittel ein Bulk-Signal aus der Spannung an einem zweiten Anschluß des gesteuerten Widerstandes für den den zweiten Mitteln zugeordneten MOS-Transistor generieren.

3. Schaltungsanordnung nach Anspruch 1, dadurch gekennzeichnet,
daß die Mittel zur Generierung des oder der Bulk-Signale Transistoren aufweisen.

4. Schaltungsanordnung nach Anspruch 1, dadurch gekennzeichnet,
daß die Mittel zur Generierung des Bulk-Signals einen PNP-Bipolar-Transistor aufweisen, dessen Basis mit einem der Anschlüsse der Schaltungsanordnung, dessen Kollektor mit einem Bezugspotential und dessen Emitter mit einer gegen ein positives Versorgungspotential gekoppelt Stromquelle sowie mit dem Bulk-Anschluß eines PMOS-Transistors gekoppelt sind, dessen Source-Drain-Strecke zur Generierung des Widerstandes eingesetzt wird.

5. Schaltungsanordnung nach Anspruch 1, dadurch gekennzeichnet,
daß die Mittel zur Generierung des Bulk-Signals einen NPN-Bipolar-Transistor aufweisen, dessen Basis mit einem der Anschlüsse der Schaltungsanordnung, dessen Kollektor mit einem positiven Versorgungspotential und dessen Emitter mit einer einer gegen ein Bezugspotential gekoppelten Stromquelle sowie mit dem Bulk-Anschluß eines NMOS-Transistors gekoppelt sind, dessen Source-Drain-Strecke zur Generierung des Widerstandes eingesetzt wird.

6. Schaltungsanordnung nach Anspruch 1, dadurch gekennzeichnet,
daß die Mittel zur Generierung des Bulk-Signals einen PMOS-Transistor aufweisen, dessen Gate-Anschluß mit einem der Anschlüsse der Schaltungsanordnung, dessen Drain-Anschluß mit einem Bezugspotential und dessen Source- und Bulk-Anschlüsse mit einer gegen ein positives Versorgungspotential gekoppelten Stromquelle sowie mit dem Bulk-Anschluß eines PMOS-Transistors gekoppelt sind, dessen Source-Drain-Strecke zur Generierung des Widerstandes eingesetzt wird.

7. Schaltungsanordnung nach Anspruch 1, dadurch gekennzeichnet,
daß die Mittel zur Generierung des Bulk-Signals einen NMOS-Transistor aufweisen, dessen Gate-Anschluß mit einem der Anschlüsse der Schaltungsanordnung, dessen Drain-Anschluß mit einem positiven Bezugspotential und dessen Source- und Bulk-Anschlüsse mit einer gegen ein Bezugspotential gekoppelten Stromquelle sowie mit dem Bulk-Anschluß eines NMOS-Transistors gekoppelt sind, dessen Source-Drain-Strecke zur Generierung des Widerstandes eingesetzt wird.

8. Schaltungsanordnung nach Anspruch 1, dadurch gekennzeichnet,
daß zu jedem der MOS-Transistoren, deren Source-Drain-Strecken zur Generierung des Widerstandes eingesetzt werden, jeweils ein Ohmscher Widerstand in Reihe geschaltet ist.
